# EUROPEAN PATENT APPLICATION

(11) **EP 1 126 519 A2**
(43) Date of publication of application: **22.08.2001**
(21) Application number: 01000021.4
(22) Date of filing: 19.02.2001
(51) Int. Cl.: H01L 23/485

(54) **Structure and method for bond pads of copper-metallized intergrated circuits**

(30) Priority: 18.02.2000 US 183405 P; 24.03.2000 US 191949 P
(71) Applicant: Texas Instruments Incorporated, Dallas, Texas 75251 (US)
(72) Inventor: Stierman, Roger J., Dallas Texas 75248 (US); Amador, Gonzalo, Dallas Texas 75230 (US); Test, Howard R., Plano Texas 75075 (US)
(74) Representative: Holt, Michael

(57) **Abstract**

A robust, reliable and low-cost metal structure and process enabling electrical wire/ribbon connections to the interconnecting copper metallization of integrated circuits. The structure comprises a layer of first barrier metal, deposited on the non-oxidized copper surface, having a copper diffusion coefficient of less than 1 x 10E-23 cm²/s at 250 °C and a thickness from about 0.5 to 1.5 µm. It further comprises a layer of second barrier metal on the layer of first barrier metal, having a diffusion coefficient of the first barrier metal of less than 1 x 10E-14 cm²/s at 250 °C and a thickness of less than 1.5 µm. It finally comprises an outermost layer of bondable metal, onto which a metal wire is bonded for metallurgical connection.

The first barrier metal is selected from a group consisting of nickel, cobalt, chromium, molybdenum, titanium, tungsten, and alloys thereof. The second barrier metal is selected from a group consisting of palladium, cobalt, platinum and osmium. The outermost metal layer is selected from a group consisting of gold, platinum, and silver.

## Description

### BACKGROUND OF THE INVENTION

The present invention is related in general to the field of semiconductor devices and processes and more specifically to the design and fabrication of metal caps for bond pads of copper metallized integrated circuits.

### DESCRIPTION OF THE RELATED ART

In integrated circuits (IC) technology, pure or doped aluminum has been the metallization of choice for interconnection and bond pads for more than four decades. Main advantages of aluminum include easy of deposition and patterning. Further, the technology of bonding wires made of gold, copper, or aluminum to the aluminum bond pads has been developed to a high level of automation, miniaturization, and reliability. Examples of the high technical standard of wire bonding to aluminum can be found in U.S. Patents # 5,455,195, issued on Oct. 3, 1995 (Ramsey et al., "Method for Obtaining Metallurgical Stability in Integrated Circuit Conductive Bonds"); # 5,244,140, issued on Sep. 14, 1993 (Ramsey et al., "Ultrasonic Bonding Process Beyond 125 kHz"); # 5,201,454, issued on Apr. 13, 1993 (Alfaro et al., "Process for Enhanced Intermetallic Growth in IC Interconnections"); and # 5,023,697, issued on Jun. 11, 1991 (Tsumura, "Semiconductor Device with Copper Wire Ball Bonding").

In the continuing trend to miniaturize the ICs, the RC time constant of the interconnection between active circuit elements increasingly dominates the achievable IC speed-power product. Consequently, the relatively high resistivity of the interconnecting aluminum now appears inferior to the lower resistivity of metals such as copper. Further, the pronounced sensitivity of aluminum to electromigration is becoming a serious obstacle. Consequently, there is now a strong drive in the semiconductor industry to employ copper as the preferred interconnecting metal, based on its higher electrical conductivity and lower electromigration sensitivity. From the standpoint of the mature aluminum interconnection technology, however, this shift to copper is a significant technological challenge.

Copper has to be shielded from diffusing into the silicon base material of the ICs in order to protect the circuits from the carrier lifetime killing characteristic of copper atoms positioned in the silicon lattice. For bond pads made of copper, the formation of thin copper(I)oxide films during the manufacturing process flow has to be prevented, since these films severely inhibit reliable attachment of bonding wires, especially for conventional gold-wire ball bonding. In contrast to aluminum oxide films overlying metallic aluminum, copper oxide films overlying metallic copper cannot easily be broken by a combination of thermocompression and ultrasonic energy applied in the bonding process. As further difficulty, bare copper bond pads are susceptible to corrosion.

In order to overcome these problems, a process has been disclosed to cap the clean copper bond pad with a layer of aluminum and thus re-construct the traditional situation of an aluminum pad to be bonded by conventional gold-wire ball bonding. A suitable bonding process is described in U.S. Patent # 5,785,236, issued on Jul. 28, 1998 (Cheung et al., "Advanced Copper Interconnect System that is Compatible with Existing IC Wire Bonding Technology"). The described approach, however, has several shortcomings.

First, the fabrication cost of the aluminum cap is higher than desired, since the process requires additional steps for depositing metal, patterning, etching, and cleaning. Second, the cap must be thick enough to prevent copper from diffusing through the cap metal and possibly poisoning the IC transistors. Third, the aluminum used for the cap is soft and thus gets severely damaged by the markings of the multiprobe contacts in electrical testing. This damage, in turn, becomes so dominant in the ever decreasing size of the bond pads that the subsequent ball bond attachment is no longer reliable.

An urgent need has therefore arisen for a metallurgical bond pad structure suitable for ICs having copper interconnection metallization which combines a low-cost method of fabricating the bond pad structure, a perfect control of up-diffusion, and a reliable method of bonding wires to these pads. The bond pad structure should be flexible enough to be applied for different IC product families and a wide spectrum of design and process variations. Preferably, these innovations should be accomplished while shortening production cycle time and increasing throughput, and without the need of expensive additional manufacturing equipment.

### SUMMARY OF THE INVENTION

The present invention discloses a robust, reliable and low-cost metal structure and process enabling electrical wire connections to the interconnecting copper metallization of integrated circuits (IC). The structure comprises a layer of first barrier metal, deposited on the non-oxidized copper surface, having a copper diffusion coefficient of less than 1 x 10E-23 cm²/s at 250 °C and a thickness from about 0.5 to 1.5 µm. It further comprises a layer of second barrier metal on the layer of first barrier metal, having a diffusion coefficient of the first barrier metal of less than 1 x 10E-14 cm²/s at 250 °C and a thickness of less than 1.5 µm. It finally comprises an outermost layer of bondable metal, onto which a metal wire is bonded for metallurgical connection.

The first barrier metal is selected from a group consisting of nickel, cobalt, chromium, molybdenum, titanium, tungsten, and alloys thereof. The second barrier metal is selected from a group consisting of palladium, cobalt, platinum and osmium. The outermost metal layer is selected from a group consisting of gold, platinum, and silver.

The present invention is related to high density and high speed ICs with copper interconnecting metallization, especially those having high numbers of metallized inputs/outputs, or "bond pads". These circuits can be found in many device families such as processors, digital and analog devices, logic devices, high frequency and high power devices, and in both large and small area chip categories.

It is an aspect of the present invention to be applicable to bond pad area reduction and thus supports the shrinking of IC chips. Consequently, the invention helps to alleviate the space constraint of continually shrinking applications such as cellular communication, pagers, hard disk drives, laptop computers and medical instrumentation.

Another aspect of the invention is to fabricate the bond pad metal caps by the self-defining process of electroless deposition, thus avoiding costly photolithographic and alignment techniques.

Another aspect of the invention is to be guided by the metal diffusion coefficients for selecting the appropriate pair of metals and the coordinated layer thicknesses in order to minimize up-diffusion at the elevated bonding temperatures and subsequent bond-inhibiting chemical reactions.

Another aspect of the invention is to advance the process and reliability of wafer-level multi-probing by eliminating probe marks and subsequent bonding difficulties.

Another object of the invention is to provide design and process concepts which are flexible so that they can be applied to many families of semiconductor products, and are general so that they can be applied to several generations of products.

Another object of the invention is to use only designs and processes most commonly employed and accepted in the fabrication of IC devices, thus avoiding the cost of new capital investment and using the installed fabrication equipment base.

These objects have been achieved by the teachings of the invention concerning selection criteria and process flows suitable for mass production. Various modifications have been successfully employed to satisfy different selections of bonding technologies.

In the first embodiment of the invention, an immersion layer of bondable metal is deposited (for instance, about 40 nm platinum) over the non-oxidized surface of the copper of the bond pad in order to prevent excessive copper diffusion to the surface.

In the second embodiment of the invention, the non-oxidized surface of the copper of the bond pad is seeded by a metal such as palladium and covered with a layer of a barrier metal such as nickel. The thickness of this barrier layer has to be such that it prevents excessive copper up-diffusion at the elevated temperatures of the bonding operation. The outermost layer is a bondable metal such as palladium or gold. The layer thickness has to be such that it prevents nickel up-diffusion to the surface, where it would oxidize and impede wire bonding.

In the third embodiment of the invention, the non-oxidized surface of the copper metallization of the bond pad is seeded by palladium or tin and covered with a layer of nickel. A subsequent layer of palladium is deposited in a thickness limiting the up-diffusion of nickel. Finally, a thin outermost layer of bondable metal such as gold is deposited before the bonding operation with gold wires.

In all preferred embodiments, the various metal layers are deposited by electroless plating, thus avoiding the need for expensive photolithographic definition steps.

The technical advances represented by the invention, as well as the aspects thereof, will become apparent from the following description of the preferred embodiments of the invention, when considered in conjunction with the accompanying drawings and the novel features set forth in the appended claims.

### BRIEF DESCRIPTION OF THE DRAWINGS

The present invention will now be further described by way of example, with reference to the accompanying drawings in which:

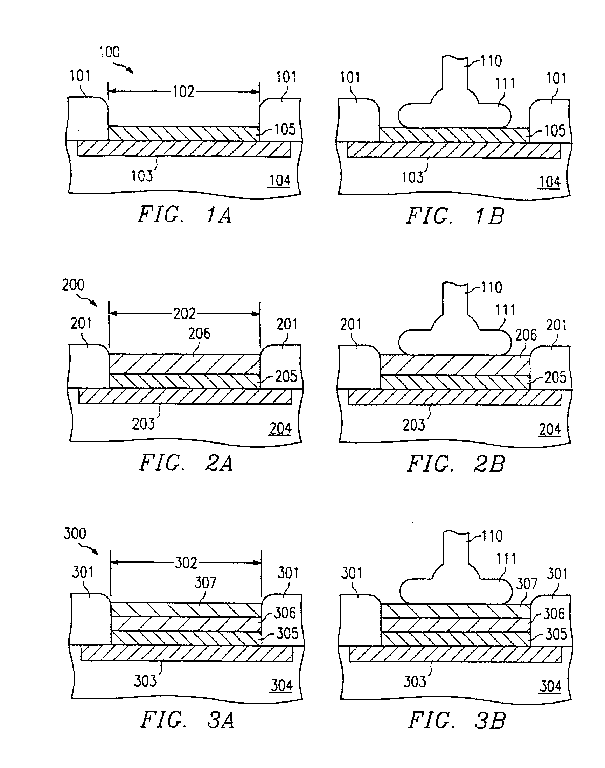

FIGs. 1A and 1B illustrate schematic cross sections of a first embodiment of the invention.
FIG. 1A shows a bondable cap over a bond pad of an integrated circuit having copper metallization.
FIG. 1B shows the bond pad of FIG. 1A including a ball-bonded wire.
FIGs. 2A and 2B illustrate schematic cross sections of a second embodiment of the invention.
FIG. 2A shows a bondable cap of stacked layers over a bond pad of an integrated circuit having copper metallization.
FIG. 2B shows the bond pad of FIG. 2A including a ball-bonded wire.
FIGs. 3A and 3B illustrate schematic cross sections of a third embodiment of the invention.
FIG. 3A shows a bondable cap of stacked layers over a bond pad of an integrated circuit having copper metallization.
FIG. 3B shows the bond pad of FIG. 3A including a ball-bonded wire.

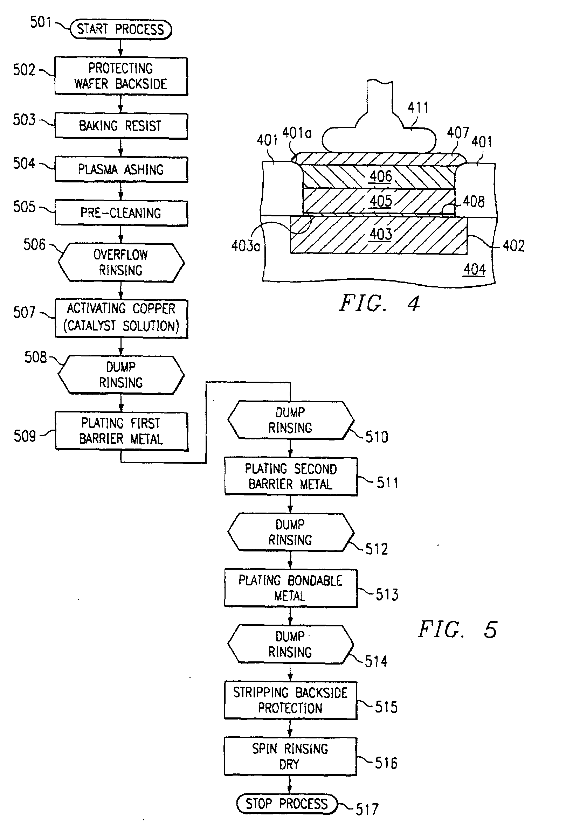

FIG. 4 is a more detailed yet still schematic cross section of a third embodiment of the invention.
FIG. 5 illustrates a block diagram of the process flow for fabricating the bond pad cap according to a third embodiment of the invention.

APPENDIX: The Table is listing the calculated thicknesses of barrier metal layers which are required to reduce the up-diffusion of the underlying metal by more than 80 % compared with the absence of the barrier metal.

### DETAILED DESCRIPTION OF THE PREFERRED EMBODIMENTS

FIG. 1A shows a schematic cross section of the first embodiment of the invention, generally designated 100. An integrated circuit (IC) has copper interconnecting metallization and is covered by a moisture-impenetrable protective overcoat 101. This overcoat is usually made of silicon nitride, commonly 500 to 1000 nm thick. A window 102 is opened in the overcoat in order to expose portion of the copper metallization 103. Not shown in FIG. 1A is the underlayer embedding the copper and preventing its diffusion into parts of the IC (usually made of tantalum nitride, tantalum silicon nitride, tungsten nitride, tungsten silicon nitride, titanium, titanium nitride, or titanium tungsten).

In FIG. 1A, the dielectric IC portions 104 are only summarily indicated. These electrically insulating portions may include not only the traditional plasma-enhanced chemical vapor deposited dielectrics such as silicon dioxide, but also newer dielectric materials having lower dielectric constants, such as silicon-containing hydrogen silsesquioxane, organic polyimides, aerogels, and parylenes, or stacks of dielectric layers including plasma-generated or ozone tetraethylorthosilicate oxide. Since these materials are less dense and mechanically weaker than the previous standard insulators, the dielectric under the copper is often reinforced. Examples can be found in U.S. Patent applications # 60/085,876, filed on 05/18/98 (Saran et al., "Fine Pitch System and Method for Reinforcing Bond Pads in Semiconductors"), and # 60/092,961, filed 07/14/98 (Saran, "System and Method for Bonding over Active Integrated Circuits").

Since copper is susceptible to corrosion and even thin copper(I)oxide films are difficult to bond to, the present invention provides structures and processes of a cap formed over the exposed copper, as described in FIGs. 1, 2 and 3. According to the invention, the cap consists of a metal and has a coordinated thickness such that it satisfies three requirements:
* The cap acts as a barrier against the up-diffusion of copper to the surface of the cap where the copper might impede the subsequent wire bonding operation. Specifically, for the cap the metal selection and thickness are coordinated such that the cap reduces the up-diffusion of copper at 250 °C by more than 80 % compared with the absence of the barrier metal.
* The cap is fabricated by a technique, which avoids expensive photolithographic steps. Specifically, an electroless process is used to deposit the cap metal layer.
* The cap metal has a surface which is bondable. Specifically, conventional ball and wedge bonding techniques can be used to connect metal wires and other coupling members metallurgically to the bond pad.

As indicated in FIGs. 1B, 2B, and 3B, wire ball bonding is the preferred method of using coupling members to create electrical connections. Another method is ribbon bonding employing wedge bonders. In contrast to wedge bonding, ball bonding operates at elevated temperatures for which the materials and processes of this invention need to be harmonized.

The wire bonding process begins by positioning both the IC chip with the bond pads and the object, to which the chip is to be bonded, on a heated pedestal to raise their temperature to between 170 and 300 °C. A wire 110 (in FIGs. 1B, 2B, and 3B), typically of gold, gold-beryllium alloy, other gold alloy, copper, aluminum, or alloys thereof, having a diameter typically ranging from 18 to 33 µm, is strung through a heated capillary where the temperature usually ranges between 200 and 500 °C. At the tip of the wire, a free air ball is created using either a flame or a spark technique. The ball has a typical diameter from about 1.2 to 1.6 wire diameters. The capillary is moved towards the chip bonding pad (102 in FIG. 1A) and the ball is pressed against the metallization of the bonding pad (layer 105 in FIGs. 1A and 1B). A combination of compression force and ultrasonic energy creates the formation of a strong metallurgical bond by metal interdiffusion. At time of bonding, the temperature usually ranges from 150 to 270 °C. In FIGs. 1B, 2B, and 3B, schematic form 111 exemplifies the final shape of the attached "ball" in wire ball bonding.

It is important for the present invention that recent technical advances in wire bonding now allow the formation of small yet reliable ball contacts and tightly controlled shape of the wire loop. Ball pitches as small as between 75 and 40 µm can be achieved. Such advances can, for instance, be found in the computerized bonder 8020 by Kulicke & Soffa, Willow Grove, PA, U.S.A., or in the ABACUS SA by Texas Instruments, Dallas, TX, U.S.A. Moving the capillary in a predetermined and computer-controlled manner through the air will create a wire looping of exactly defined shape. Finally, the capillary reaches its desired destination and is lowered to touch the contact pad of the object. With an imprint of the capillary, a metallurgical stitch bond is formed, and the wire is flamed off to release the capillary. Stitch contacts are small yet reliable; the lateral dimension of the stitch imprint is about 1.5 to 3 times the wire diameter (its exact shape depends on the shape of the capillary used, such as capillary wall thickness and capillary footprint).

Examples for barrier cap metals 103 in FIGs. 1A and 1B are platinum, rhodium, iridium, and osmium. In these metals, copper has a diffusion coefficient of less than 1 x 10E-23 cm²/s at 250 °C. Consequently, these metals are good copper diffusion barriers. For these metals, the layer thicknesses required to reduce copper diffusion by more than 80 % compared to the absence of the layers are obtained by diffusion calculations. As an example, the Table of the Appendix lists the layer thickness of platinum when copper is diffusing at 250 °C or 160 °C, with diffusion time (min) as parameter. Generally, a barrier thickness from about 0.5 to 1.5 µm will safely meet the copper reduction criterion.

The metals quoted above can be deposited by electroless plating (more detail about this technique below). Furthermore, these metals are bondable. A drawback, however, of the metals quoted is their high cost.

A lower cost solution is offered by the second embodiment of the invention, generally designated 200 in FIG. 2A. 201 indicates the protective overcoat defining the size 202 of the bond pad. 203 is the copper metallization of the bond pad, and 204 the underlying dielectric material. The metal cap over the copper 203 is provided by two layers:

Layer 205 is positioned over copper 203, sometimes deposited on a seed metal layer (see FIG. 4). Examples for layer 205 are nickel, cobalt, chromium, molybdenum, titanium, tungsten, and alloys thereof. These metals are inexpensive and can be deposited by electroless plating; however, they are poorly bondable. In these metals, copper has a diffusion coefficient of less than 1 X 10E-23 cm²/s at 250 °C. Consequently, these metals are good copper diffusion barriers. The layer thicknesses required to reduce copper diffusion by more than 80 % compared to the absence of the layers are obtained by diffusion calculations. As an example, the Table of the Appendix lists the layer thickness of nickel when copper is diffusing at 250 °C or 160 °C, with diffusion time (min) as parameter. Generally, a barrier thickness from about 0.5 to 1.5 µm will safely meet the copper reduction criterion.

Layer 206 is positioned over layer 205 as the outermost layer of the cap; they are bondable so that they can accept the wire bond 111. Examples for layer 206 are gold, platinum, palladium, and silver. In addition, these metals have a diffusion coefficient for the metals used in barrier 205 (such as nickel) of less than 1 x 10E-14 cm²/s at 250 °C. Consequently, these metals are good diffusion barriers for the materials of layer 205. Again, the layer thicknesses required to reduce the up-diffusion of metal used in layer 205 by more than 80 % compared to the absence of layer 206 are obtained from diffusion calculations. As an example, the Table of the Appendix lists the layer thickness (µm) of gold when nickel is up-diffusing at 250 °C or 160 °C, with diffusion time (min) as parameter. Generally an outermost layer thickness of 1.5 µm or somewhat less will safely meet the reduction criterion for metal diffusing from layer 205.

A preferred solution is offered by the third embodiment of the invention, providing further cost reduction and bondability improvement. The overall thickness of the bondable metal layer is reduced by a separation into two layers, each selected on their mutual diffusion characteristics. The third embodiment is generally designated 300 in FIG. 3A; 301 indicates the protective overcoat defining the size 302 of the bond pad. 303 is the copper metallization of the bond pad, and 304 the underlying dielectric material. The metal cap over the copper 303 is provided by three layers:

Layer 305 is positioned over copper area 303, sometimes deposited on a seed metal layer (not shown in FIG. 3A and 3B, but see FIG. 4). Layer 305 consists of a metal acting as a diffusion barrier against copper. Examples for layer 305 are nickel, cobalt, chromium, molybdenum, titanium, tungsten, and alloys thereof. These metals are inexpensive and can be deposited by electroless plating; however, they are poorly bondable. As mentioned above, in these metals copper has a diffusion coefficient of less than 1 x 10E-23 cm²/s at 250 °C. Consequently, these metals are good copper diffusion barriers. The layer thicknesses, required to reduce copper diffusion by more than 80 % compared to the absence of the layers, are obtained by diffusion calculations. As an example, the Table of the Appendix lists the layer thickness of nickel when copper is diffusing at 250 °C or 160 °C, with diffusion time (min) as parameter. Generally, a barrier thickness from about 0.5 to 1.5 µm will safely meet the copper reduction criterion.

Layer 306 is positioned over layer 305 as an effective diffusion barrier against the up-diffusing metal used in layer 305. The intent is to de-emphasize the barrier function of the outermost layer 307, and rather emphasize its bondability function. Consequently, the thickness required for the outermost layer 307 can be reduced, thus saving cost. Examples for layer 306 are palladium, cobalt, platinum, and osmium. Examples for layer 307 are gold, platinum, and silver.

Metals used for layer 306 (such as palladium) have a diffusion coefficient for the metals used in barrier layer 305 (such as nickel) of less than 1 x 10E-14 cm²/s at 250 °C. The layer thicknesses required to reduce the up-diffusion of metal used in layer 305 by more than 80 % compared to the absence of layer 306 are obtained from diffusion calculations. As an example, the Table of the Appendix lists the layer thickness (µm) of palladium when nickel is up-diffusing at 250 °C or 160 °C, with diffusion time (min) as parameter. Generally, a thickness of layer 305 of about 0.4 to 1.5 µm will safely meet the reduction criterion for metal diffusing from layer 305.

The thickness of the bondable outermost layer 307 (such as gold) can now be reduced to the range of about 0.02 to 0.1 µm.

FIG. 4 summarizes the third embodiment of the present invention in more detail; most dimension ranges are quoted in FIGs. 1 to 3, and the electroless plating and other fabrication process steps are discussed in FIG. 5. The protective overcoat 401 has an opening, defining the size of the bond pad, and a thickness sufficient to accommodate most of the stacked layers, which cap the bond pad IC copper metallization 403. The copper trace 403 is imbedded in refractory metal shield 402 (for example, tantalum nitride), which is surrounded by dielectric 404 (re-enforcement methods see above).

Directly facing the cleaned and non-oxidized copper surface 403a is the first layer of the cap, a thin layer 408 of seed metal (for example, palladium, about 5 to 10 nm thick; another choice is tin). Immediately following the seed metal layer is metal layer 405 (for example, nickel) as a barrier against up-diffusing copper. On top of this first barrier layer is metal layer 406 (for example, palladium) as a barrier against up-diffusing first barrier metal (such as nickel).

The outermost layer of the cap is metal layer 707 (for example, gold), which is metallurgically bonded by wire "ball" 411. As FIG. 4 shows, the electroless plating process may deposit some metal of the layers onto the protective overcoat beyond the periphery 401a of the bond pad opening.

The electroless process used for fabricating the bond pad cap of FIG. 4 is detailed in FIG. 5. After the bond pads have been opened in the protective overcoat, exposing the copper IC metallization in bond pad areas, the cap deposition process starts at 501; the sequence of process steps is as follows:
- Step 502: Coating the backside of the silicon IC wafer with resist using a spin-on technique. This coat will prevent accidental metal deposition on the wafer backside.
- Step 503: Baking the resist, typically at 110 °C for a time period of about 30 to 60 minutes.
- Step 504: Cleaning of the exposed bond pad copper surface using a plasma ashing process for about 2 minutes.
- Step 505: Cleaning by immersing the wafer, having the exposed copper of the bond pads, in a solution of sulfuric acid, nitric acids, or any other acid, for about 50 to 60 seconds.
- Step 506: Rinsing in overflow rinser for about 100 to 180 seconds.
- Step 507: Immersing the wafer in a catalytic metal chloride solution, such as palladium chloride, for about 40 to 80 seconds "activates" the copper surface, i.e., a layer of seed metal (such as palladium) is deposited onto the clean non-oxidized copper surface.
- Step 508: Rinsing in dump rinser for about 100 to 180 seconds.
- Step 509: Electroless plating of first barrier metal. If nickel is selected, plating between 150 to 180 seconds will deposit about 0.4 to 0.6 µm thick nickel.
- Step 510: Rinsing in dump rinser for about 100 to 180 seconds.
- Step 511: Electroless plating of second barrier metal. If palladium is selected, plating between 150 to 180 seconds will deposit about 0.4 to 0.6 µm thick palladium.
- Step 512: Rinsing in dump rinser for about 100 to 180 seconds.
- Step 513: Electroless plating of bondable metal. If only thin metal layer is needed, immersion process with self-limiting surface metal replacement is sufficient. If gold is selected, plating between 400 and 450 seconds will deposit approximately 30 nm thick gold. If thicker metal layer (0.5 to 1.5 µm thick) is required, the immersion process is followed by an autocatalytic process step.
- Step 514: Rinsing in dump rinser for about 100 to 180 seconds.
- Step 515: Stripping wafer backside protection resist for about 8 to 12 minutes.
- Step 516: Spin rinsing and drying for about 6 to 8 minutes.
The bond pad cap fabrication process stops at 517.

The subsequent metallurgical connection of metal wires or ribbons by a ball or wedge bonding process is described above.

While this invention has been described in reference to illustrative embodiments, this description is not intended to be construed in a limiting sense. Various modifications and combinations of the illustrative embodiments, as well as other embodiments of the invention, will be apparent to persons skilled in the art upon reference to the description. As an example, the invention can be applied to IC bond pad metallizations other than copper, which are difficult or impossible to bond by conventional ball or wedge bonding techniques, such as alloys of refractory metals and noble metals. As another example, the invention can be extended to batch processing, further reducing fabrication costs. As another example, the invention can be used in hybrid technologies of wire/ribbon bonding and solder interconnections.

## Claims

1. A metal structure for a bond pad of an integrated circuit having copper interconnecting metallization, comprising:
a bond pad surface of non-oxidized copper; and
a bondable metal layer, deposited on said copper surface, having a copper diffusion coefficient of less than 1 x 10E-23 cm²/s at 250 °C and a thickness from about 0.5 to 1.5 µm.

2. The bond pad structure according to Claim 1 wherein said bondable metal layer is selected from a group consisting of platinum, rhodium, iridium, and osmium.

3. A structure for metallurgical connections between metal wires and bond pads positioned on integrated circuits having a copper interconnecting metallization, comprising:
a bond pad surface of non-oxidized copper;
a layer of barrier metal deposited on said copper surface, having a copper diffusion coefficient of less than 1 x 10E-23 cm²/s at 250 °C and a thickness from about 0.5 to 1.5 µm;
an outermost layer of bondable metal, having a diffusion coefficient of the barrier metal of less than 1 x 10E-14 cm²/s at 250 °C and a thickness of less than 1.5 µm; and
one of said metal wires bonded to said outermost bondable metal.

4. The structure according to Claim 3 wherein said barrier metal layer is selected from a group consisting of nickel, cobalt, chromium, molybdenum, titanium, tungsten, and alloys thereof.

5. The structure according to Claim 3 or Claim 4, wherein said bondable metal layer is selected from a group consisting of gold, platinum, palladium, and silver.

6. The structure according to any of Claims 3 to 5, further comprising a thin seed metal layer between said non-oxidized copper and said barrier metal layer.

7. The structure according to Claim 6 wherein said seed metal is palladium or tin.

8. The structure according to any of Claims 3 to 7, wherein said metal wires are selected from a group consisting of gold, copper, aluminum, and alloys thereof.

9. A structure for metallurgical connections between metal wires and bond pads positioned on integrated circuits having copper interconnecting metallization, comprising:
a bond pad surface of non-oxidized copper;
a layer of first barrier metal, deposited on said copper surface, having a copper diffusion coefficient of less than 1 x 10E-23 cm²/s at 250 °C and a thickness from about 0.5 to 1.5 µm;
a layer of second barrier metal on said layer of first barrier metal, having a diffusion coefficient of the first barrier metal of less than 1 x 10E-14 cm²/s at 250 °C and a thickness of less than 1.5 µm;
an outermost layer of bondable metal having a thickness from about 0.02 to 0.1 µm; and
one of said metal wires bonded to said outermost bondable metal.

10. The structure according to Claim 9 wherein said first barrier metal layer is selected from a group consisting of nickel, cobalt, chromium, molybdenum, titanium, tungsten, and alloys thereof.

11. The structure according to Claim 9 or Claim 10, wherein said second barrier metal layer is selected from a group consisting of palladium, cobalt, platinum, and osmium.

12. The structure according to any of Claims 9 to 12 wherein said bondable metal layer is selected from a group consisting of gold, platinum, and silver.

13. The structure according to any of Claims 9 to 12 further comprising a thin seed metal layer between said non-oxidized copper and said layer of first barrier metal.

14. The structure according to Claim 13 wherein said seed metal is palladium or tin.

15. The structure according to any of Claims 9 to 14, wherein said metal wires are selected from a group consisting of gold, copper, aluminum, and alloys thereof.

16. A method for forming metallurgical connections between metal wires and bond pads positioned on integrated circuits having copper interconnecting metallization, comprising the steps of:
activating the surface of said copper metallization of said bond pads, depositing seed metal;
plating a layer of barrier metal by electroless deposition, said barrier metal having a copper diffusion coefficient of less than 1 x 10E-23 cm² /s at 250 °C and a thickness of about 0.5 to 1.5 µm;
plating an outermost layer of a bondable metal by electroless deposition, said bondable metal having a diffusion coefficient of the barrier metal of less than 1 x 10E-14 cm²/s at 250 °C and a thickness of less than 1.5 µm; and
bonding one of said metal wires to said outermost bondable metal.

17. The method according to Claim 16 wherein said wire bonding step comprises ball bonding or wedge bonding.

18. The method according to Claim 16 or Claim 17, wherein said bond pads are formed by a process comprising:
depositing a protective overcoat over the surface of said integrated circuit, including the surface portions having copper metallization; and
opening selected areas of said overcoat by photolithographic techniques, exposing the surface of said copper metallization.

19. The method according to Claim 18 further comprising a cleaning step after said opening step, by immersing said exposed copper surface in a solution of sulfuric acid, nitric acid, or any other acid.

20. The method according to any of Claims 16 to 19, wherein said step of activating comprises immersing the bond pads in a catalytic metal chloride solution.

21. The method according to Claim 20 wherein said metal chloride is palladium chloride, depositing palladium seeds.

22. The method according to any of Claims 16 to 21, wherein said electroless plating of said bondable metal layer is immersion plating.

23. The method according to any of Claims 16 to 22, wherein said electroless plating of said bondable metal layer is immersion plating followed by autocatalytic plating.

24. The method according to any of Claims 16 to 23 further comprising the step of electrically probing said outermost metal of said bond pad before the step of bonding, leaving substantially no probe marks.

25. The method according to any of Claims 16 to 24 wherein the process steps are executed in sequence without time delays, yet including intermediate rinsing steps.

26. A method for forming metallurgical connections between metal wires and bond pads positioned on integrated circuits having copper interconnecting metallization, comprising the steps of:
activating the surface of said copper metallization of said bond pads, depositing seed metal;
plating a layer of a first barrier metal by electroless deposition, said barrier metal having a copper diffusion coefficient of less than 1 x 10E-23 cm²/s at 250 °C and a thickness of about 0.5 to 1.5 µm;
plating a layer of a second barrier metal on said layer of first barrier metal, by electroless deposition, said second barrier metal having a diffusion coefficient of the first barrier metal of less than 1 x 10E-14 cm²/s at 250 °C and a thickness of less than 1.5 µm;
plating an outermost layer of a bondable metal by electroless deposition; and
bonding one of said metal wires to said outermost bondable metal.

27. The method according to Claim 26 further comprising a cleaning step of said copper bond pad metallization by immersing the exposed copper surface in a solution of sulfuric acid, nitric acid, or any other acid.

28. The method according to Claim 26 or Claim 27 wherein said step of activating comprises immersing the bond pads in a catalytic metal chloride solution, depositing seeds of said metal.
